# EUROPEAN PATENT APPLICATION

(11) **EP 3 396 014 A1**
(43) Date of publication of application: **31.10.2018**
(21) Application number: 16879251.3
(22) Date of filing: 14.12.2016
(51) Int. Cl.: C23C 14/24, C23C 14/54, C23C 14/02

(54) **VACUUM DEPOSITION DEVICE FOR HIGH-SPEED COATING**

(30) Priority: 23.12.2015 KR 20150185053
(71) Applicant: POSCO, Pohang-si, Gyeongsangbuk-do 37859 (KR)
(72) Inventor: NAM, Kyung Hoon, Gwangyang-si Jeollanam-do 57811 (KR); KIM, Sang Joon, Pohang-si Gyeongsangbuk-do 37664 (KR); KO, Kyoung Pil, Suncheon-si Jeollanam-do 57930 (KR); KIM, Tae Yeob, Gwangyang-si Jeollanam-do 57719 (KR); EOM, Mun Jong, Gwangyang-si Jeollanam-do 57810 (KR)
(74) Representative: Zech, Stefan Markus
(86) International application number: PCT/KR2016/014637
(87) International publication number: WO 2017/111384

(57) **Abstract**

The present invention relates to a vacuum deposition device for high-speed coating, comprising: a vacuum chamber having a reception space arranged therein; an evaporation crucible disposed in the reception space to evaporate a coating material; and a cyclone filter disposed in the reception space, wherein the cyclone filter separates a coarse particle from steam generated during the evaporation of the coating material. Therefore, the vacuum deposition device for high-speed coating can remove a coarse particle generated in the high-speed coating, prevent the rotation of steam, using a baffle inserted between a steam ejection opening and an exit of the cyclone filter, and thus obtain a coating layer having the excellent uniformity of coating.

## Description

### [Technical Field]

The present invention relates to a vacuum deposition device for high-speed coating, and more specifically, to a vacuum deposition device for high-speed coating which removes coarse particles generated during high-speed coating.

### [Background Art]

Vacuum deposition is a technology of forming a thin film by heating and evaporating a solid coating material by various methods under a vacuum condition to be changed into steam and spraying the steam to a plating target object, and a coating method is mainly classified according to a heating method.

Typical vacuum deposition methods include a thermal evaporation method, an electron beam evaporation method, and an electro-magnetic levitation evaporation method.

The thermal evaporation method is a method of coating a substrate by heating and evaporating a solid coating material, which is put in a filament, a boat, or a crucible made of metal, ceramic, or graphite, by resistive heating. Since the method is limited to heating of a coating material by resistive heating, it is almost impossible to coat a high melting point material such as titanium, chrome or the like. Therefore, the method is widely used for coating a low melting point material such as zinc, magnesium or the like.

The electron beam evaporation method allows a high melting point material to be evaporated by locally heating a solid coating material, which is put in a water-cooled copper or ceramic crucible, by an electron beam. However, there is a disadvantage of low energy efficiency due to heat loss caused by a contact between the evaporated material and the crucible.

The electro-magnetic levitation evaporation method is a technology of generating coating steam by levitating and heating an electrically conductive material in an electro-magnetic coil, especially a metal, by electromagnetic force in a vacuum atmosphere, and continuously spraying the coating steam to a moving substrate through a ceramic tube and a heated steam box. The method is used for a strip to be coated with a low melting point metal, such as zinc, magnesium or the like, and has an advantage of high energy efficiency.

Determining a coating speed in the vacuum deposition method depends on a heating temperature and an evaporation pressure of the coating material.

Since the evaporation pressure is an inherent property of matter, it cannot be controlled, and thus a heating temperature of a coating material should increase so that the coating speed increases.

To increase a heating temperature of a coating material, power of a resistive heating heater, an electron beam, or electro-magnetic coil should increase. However, when the temperature of the coating material excessively increases due to the increase in the power, coarse particles are discharged from a mass of the coating material due to an effect of simultaneous evaporation and boiling, and a specimen is coated with the coarse particles, thus quality is degraded.

That is, heating power of the coating material should increase so that high speed coating is performed, but the high speed coating has limitations due to the coarse particles that degrade the quality of coating.

Technologies for removing coarse particles generated during the vacuum deposition is mainly classified into a technology of preventing boiling of coarse particles, a technology of preventing condensation due to heat radiating expansion at a steam ejection opening, and a technology of inserting a member configured to block coarse particles.

In the case of the technology of preventing boiling of coarse particles, heaters are mounted not only on an outside of a vacuum deposition crucible but also above a coating material in the crucible to heat the coating material, and a carbon block has a gap with a surface of the coating material to prevent boiling of the coating material due to an increase in temperature of the surface of the coating material, and thus production of coarse particles is prevented.

The technology can prevent boiling of coarse particles generated during deposition but is inadequate to technology of removing coarse particles at a level applicable to high speed coating.

That is, heating power of the coating material should increase to perform high speed coating, but it is practically difficult to perform the high speed coating while a temperature of a surface of the coating material is maintained at high temperatures while an interior temperature of the coating material is maintained under a boiling point by the technology of preventing boiling of the coating material.

The technology of preventing condensation due to heat radiating expansion at a steam ejection opening is related to Korean Patent Registration No. 10-0598717 "Source For Depositing Organic El Device Comprising Heating Unit Arranged Unequally" published on July 03, 2006.

The source for depositing an organic EL device including unequally arranged heating units uses a different technical unit but removes coarse particles by preventing steam from being condensed at the steam ejection opening by heating units additionally mounted at the steam ejection opening or concentrically disposed.

However, there is a problem in which coarse particles generated due to boiling of the coating material cannot be removed. Particularly, in the case of the high speed coating, most coarse particles are generated due to boiling of a coating material, and thus the technology has limitations in application of high speed coating.

In the technology of inserting a member blocking a coarse particle, a blocking member is used to block steam, and thus there is a problem in which a coating speed is sharply lowered.

Further, the blocking member has a problem of functioning as a medium generating coarse particles.

### [Technical Problem]

The present invention is directed to providing a vacuum deposition device for high-speed coating which prevents coarse particles with which a plating target object is coated even in high speed coating using a cyclone filter to remove the coarse particles generated during vacuum deposition.

Objects to be solved by the present invention are not limited to the above-mentioned objects, and other objects that are not mentioned may be clearly understood by those skilled in the art in the following description.

### [Technical Solution]

One aspect of the present invention provides a vacuum deposition device for high-speed coating which includes a vacuum chamber including a reception space provided therein, an evaporation crucible disposed in the reception space to evaporate a coating material, and a cyclone filter disposed in the reception space, wherein the cyclone filter is configured to separate steam generated while the coating material is evaporated from coarse particles.

The vacuum deposition device for high-speed coating may further include a baffle configured to prevent circulation of the steam discharged through the cyclone filter.

The baffle may include a plurality of horizontal plates separated from each other, and a plurality of vertical plates separated from each other and configured to be perpendicular to the horizontal plates, wherein the horizontal plates and the vertical plates may be integrally formed.

The baffle may be formed of a plurality of plates separated from each other in a circumferential direction with respect to a virtual line (C).

The cyclone filter may include a cyclone filter main body and a collecting part disposed under the cyclone filter main body, wherein the cyclone filter main body may include an inlet formed at a side surface thereof and an outlet formed at an upper portion thereof.

The collecting part may have a tapered shape in which an upper portion is wider than a lower portion.

The steam and the coarse particles generated in the evaporation crucible evaporating the coating material may be moved to the inside of the cyclone filter through the inlet, wherein the steam may be discharged to the outlet by a cyclone method, and the coarse particles may be collected in the collecting part.

When an inner diameter (D1) of the cyclone filter main body is 1, a diameter (D2) of the outlet may be in a range of 0.2 to 0.8, and a diameter D3 of a bottom of the collecting part may be in a range of 0.1 to 0.8.

A height (H1) of the cyclone filter main body may be in a range of 0.3 to 5, a height (H2) of the collecting part may be in a range of 0.3 to 10, a height (H3) of the inlet may be in a range of 0.2 to 1, and a width (W) of the inlet may be in a range of 0.1 to 0.5.

The vacuum deposition device for high-speed coating may further include a heating unit configured to heat the reception space to a predetermined temperature.

The coating material may include at least one of zinc, magnesium, and aluminum.

### [Advantageous Effects]

A vacuum deposition device for high-speed coating according to an embodiment of the present invention can remove coarse particles generated during high speed coating by inserting a cyclone filter between a steam evaporation unit and a steam ejection opening.

Further, the vacuum deposition device for high-speed coating can obtain a coating layer with high coating uniformity by preventing rotation of steam by inserting a baffle between a cyclone filter outlet and the steam ejection opening.

### [Description of Drawings]

FIG. 1 is a view showing a vacuum deposition device for high-speed coating according to one embodiment of the present invention.
FIG. 2 is a perspective view showing a cyclone filter of the vacuum deposition device for high-speed coating according to one embodiment of the present invention.
FIG. 3 is a vertical cross-sectional view showing the cyclone filter of the vacuum deposition device for high-speed coating according to one embodiment of the present invention.
FIG. 4 is a horizontal cross-sectional view showing the cyclone filter of the vacuum deposition device for high-speed coating according to one embodiment of the present invention.
FIG. 5A is a view showing a simulation result for particles with a diameter of 1 µm in the cyclone filter of the vacuum deposition device for high-speed coating according to one embodiment of the present invention.
FIG. 5B is a view showing a simulation result for particles with a diameter of 5 µm in the cyclone filter of the vacuum deposition device for high-speed coating according to one embodiment of the present invention.
FIG. 6 is a view showing an example of a baffle of the vacuum deposition device for high-speed coating according to one embodiment of the present invention.
FIG. 7 is a view showing another example of the baffle of the vacuum deposition device for high-speed coating according to one embodiment of the present invention.

### [Modes of the Invention]

While the present invention is susceptible to various modifications and alternative forms, specific embodiments thereof are shown by way of example in the drawings and will herein be described in detail. It should be understood, however, that there is no intent to limit the present invention to the particular forms disclosed, but on the contrary, the present invention is to cover all modifications, equivalents, and alternatives falling within the spirit and scope of the present invention.

It will be understood that, although the terms "first," "second," etc. may be used herein to describe various elements, the elements should not be limited by the terms. These terms are only used to distinguish one element from another. For example, a first element could be termed a second element, and similarly, a second element could be also termed a first element, without departing from the scope of the present invention. As used herein, the term "and/or" includes any and all combinations of one or more of the associated listed items.

It will be understood that when an element is referred to as being "connected" or "coupled" to another element, it can be directly connected or coupled to another element or intervening elements may be present. In contrast, when an element is referred to as being "directly connected" or "directly coupled" to another element, there are no intervening elements present.

In the following description of the embodiments, it will be understood that, when each element is referred to as being "on" or "under" another element, it can be "directly" on or under another element or can be "indirectly" formed such that an intervening element is also present. In addition, it will also be understood that "on" or "under" one element may mean an upward direction and a downward direction of the element.

The terminology used herein is for the purpose of describing particular embodiments only and is not intended to be limiting of the present invention. The singular forms "a" and "an" are intended to include the plural forms as well, unless the context clearly indicates otherwise. In the present invention, it will be further understood that the terms "comprise," "comprising," "include," and/or "including" used in this specification specify the presence of stated features, integers, steps, operations, elements, components and/or groups thereof, but do not preclude the presence or addition of one or more other features, integers, steps, operations, elements, components and/or groups thereof.

Unless otherwise defined, all terms including technical and scientific terms used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, embodiments of the present invention will be described in detail with reference to the accompanying drawings. The same reference numerals will be used to describe the same or like components, and a redundant description thereof will be omitted.

A vacuum deposition device for high-speed coating 1 according to an embodiment of the present invention may obtain a coating layer with high coating uniformity by spraying steam to a plating target object 2. In this case, the steam may be provided as steam generated when a coating material is heated and evaporated.

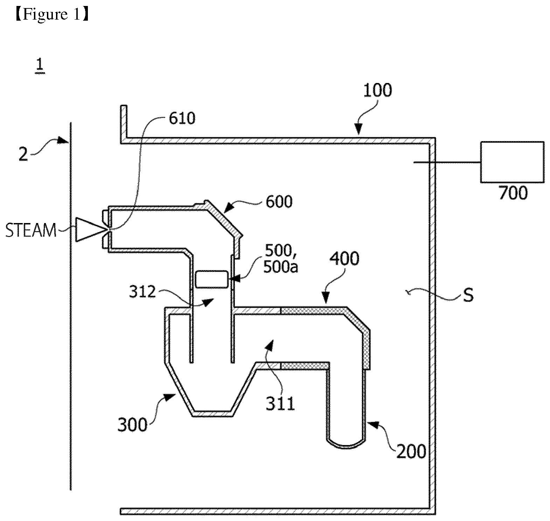

Referring to FIGS. 1 to 7, the vacuum deposition device for high-speed coating 1 according to the embodiment of the present invention may include a vacuum chamber 100, an evaporation crucible 200 disposed in the vacuum chamber 100 to evaporate a coating material, and a cyclone filter 300 separating steam from coarse particles, a connection unit 400 connecting the evaporation crucible 200 with the cyclone filter 300, baffles 500 and 500a connected to one side of the cyclone filter 300 to prevent circulation of steam, and a steam guide unit 600 guiding the steam passing through the baffles 500 and 500a to be sprayed onto the plating target object 2. For example, a substrate may be used as the plating target object 2, but the embodiment is not limited thereto.

The vacuum chamber 100 forms appearance of the vacuum deposition device for high-speed coating 1 and may include a reception space S formed therein.

The reception space S, as shown in FIG. 1, may accommodate the evaporation crucible 200, the cyclone filter 300, the connection unit 400, the baffles 500 and 500a, and the steam guide unit 600.

The evaporation crucible 200 may generate steam by evaporating the coating material. A resistive heating or electromagnetic levitation heating method may be used as the method of evaporating steam.

Further, metals such as zinc, magnesium, aluminum, and the like, may be used as the coating material.

When the coating material is heated using the evaporation crucible 200, steam and coarse particles may be generated.

Further, the steam and the coarse particles may be transferred to the cyclone filter 300 through the connection unit 400.

As shown in FIG. 1, the connection unit 400 connects the evaporation crucible 200 with the cyclone filter 300, but the embodiment is not limited thereto.

For example, one side of the evaporation crucible 200 may be connected with an inlet 311 of the cyclone filter 300 without the connection unit 400. Therefore, the steam and the coarse particles generated in the evaporation crucible 200 may be transferred to the inlet 311 of the cyclone filter 300.

The cyclone filter 300 may separate the steam from the coarse particles in a cyclone method.

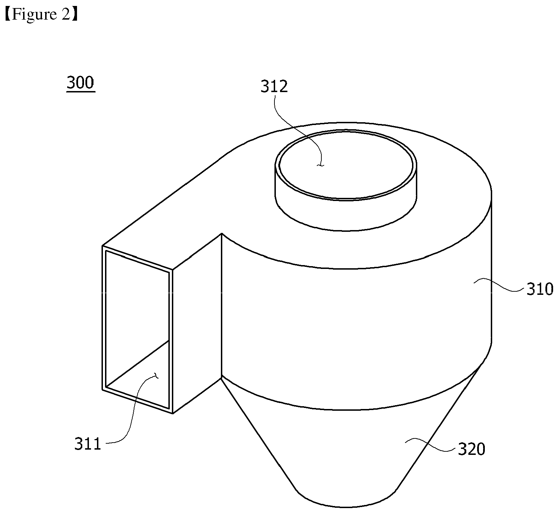

Referring to FIGS. 2 to 4, the cyclone filter 300 may include a cylindrical cyclone filter main body 310 and a collecting part 320 disposed under the cyclone filter main body 310. In this case, the cyclone filter main body 310 may include the inlet 311 formed at a side surface thereof and an outlet 312 formed at an upper portion thereof. Further, the collecting part 320 may have a tapered shape in which an upper portion is wider than a lower portion.

The inlet 311 may be disposed to communicate with the connection unit 400. As shown in FIG. 2, the inlet 311 may be disposed at the side surface of the cyclone filter main body 310. The inlet 311 may have one surface arranged on the cyclone filter main body 310 in a tangent plane manner.

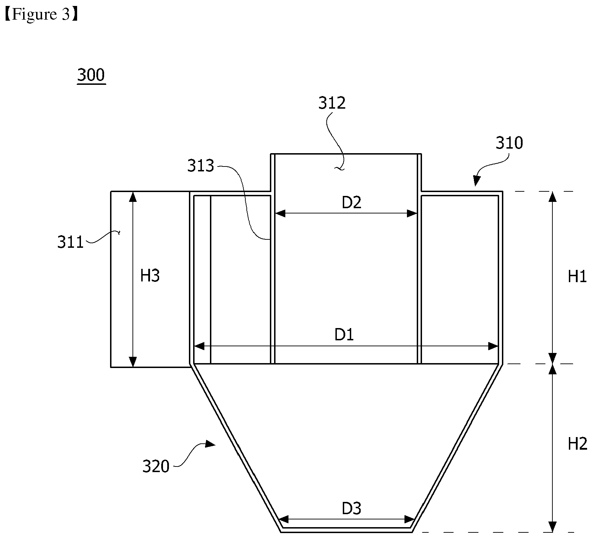

The steam and the coarse particles introduced into the cyclone filter 300 through the inlet 311 are circulated along an inner surface of the cyclone filter 300. In this case, as shown in FIG. 3, the cyclone filter main body 310 may include the outlet 312 formed therein and may further include an inner part 313 extending downward.

Therefore, the steam and the coarse particles introduced into the cyclone filter 300 through the inlet 311 rotate along an inner surface of the cyclone filter 300 and an outer surface of the inner part 313. In this case, the inner part 313 may have a cylindrical shape with a predetermined diameter D2.

When the steam and coarse particles rotate, the steam with a less mass is discharged through the outlet 312 due to a difference between drag and centrifugal force, and the coarse particles with a larger mass is transported to and collected in the collecting part 320.

Therefore, only the separated steam is transported to the baffles 500 and 500a through the outlet 312.

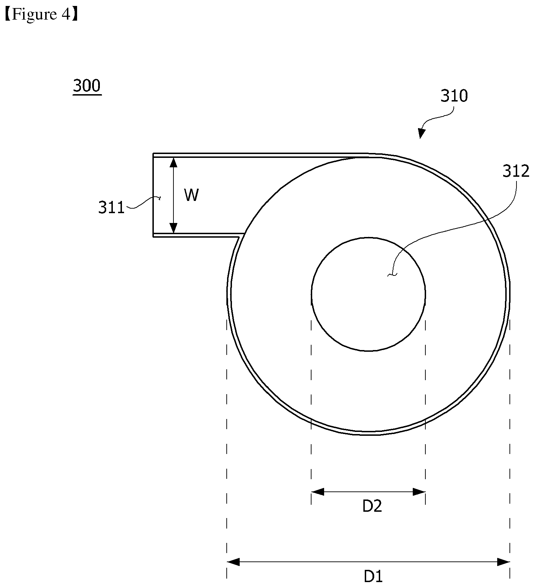

Referring to FIGS. 3 and 4, when an inner diameter D1 of the cyclone filter main body 310 is 1, a diameter D2 of the outlet 312 may be in a range of 0.2 to 0.8, and a diameter D3 of a bottom of the collecting part 320 may be in a range of 0.1 to 0.8. A height H1 of the cyclone filter main body 310 may be in a range of 0.3 to 5, and a height H2 of the collecting part 320 may be in a range of 0.3 to 1.0. Further, a height H3 of the inlet 311 may be in a range of 0.2 to 1, and a width W of the inlet 311 may be in a range of 0.1 to 0.5.

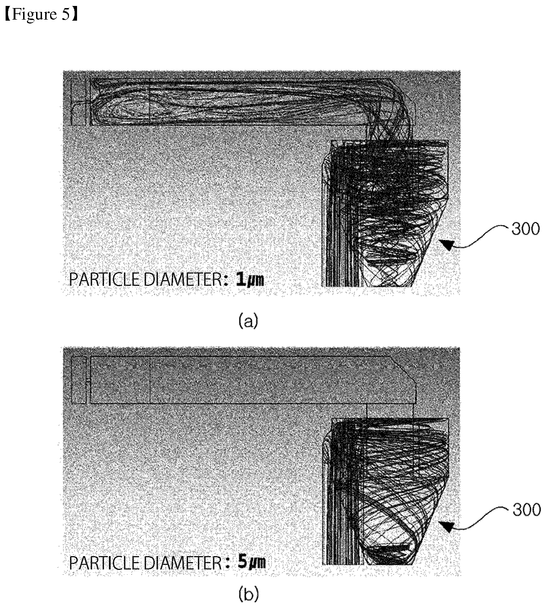

Therefore, while the steam and the coarse particles introduced through the inlet 311 rotate along an inner surface of the cyclone filter 300, steam with a particle diameter of 1 µm is discharged through the outlet 312 as shown in FIG. 5A, and coarse particles with a particle diameter of 5 µm may be separated in the collecting part 320 as shown in FIG. 5B.

Therefore, in the vacuum deposition device for high-speed coating 1, the steam with a particle diameter of 1 µm is discharged through the outlet 312, and is sprayed onto the plating target object 2 through an injection hole 610. Further, the coarse particles with a diameter of 5 µm are removed by the cyclone filter 300.

Simulation results shown in FIG. 5 are examples, but a size of the removable coarse particle may vary according to a design of a cyclone.

The baffles 500 and 500a are connected to the outlet 312 of the cyclone filter 300 to have high coating uniformity of the plating target object 2 and may prevent circulation of the steam.

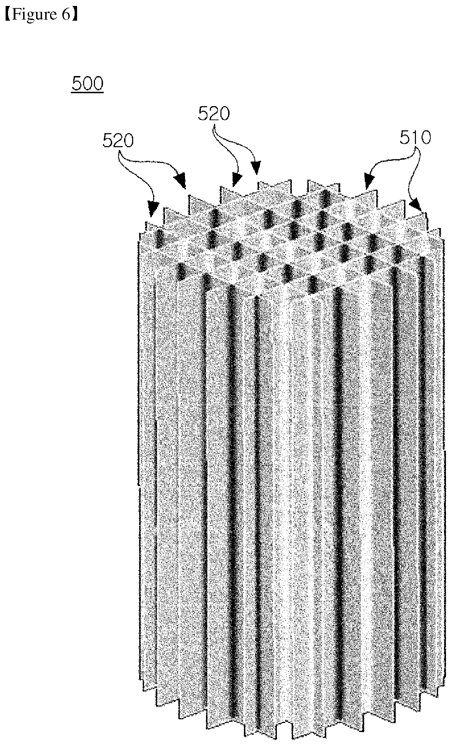

FIG. 6 is a view showing an example of a baffle of the vacuum deposition device for high-speed coating according to one embodiment of the present invention.

Referring to FIG. 6, the baffle 500 may include a plurality of horizontal plates 510 separated from each other at predetermined distances and a plurality of vertical plates 520 separated from each other at predetermined distances.

As shown in FIG. 6, the horizontal plates 510 are separated from each other at the predetermined distances, and the plurality of vertical plates 520 may be separated from each other in a direction perpendicular to the horizontal plates 510. In this case, the horizontal plates 510 and the vertical plates 520 may be integrally formed.

Therefore, the baffle 500 has a plurality of lattice shapes formed therein and a plurality of protrusions protruding outward with respect to the lattices.

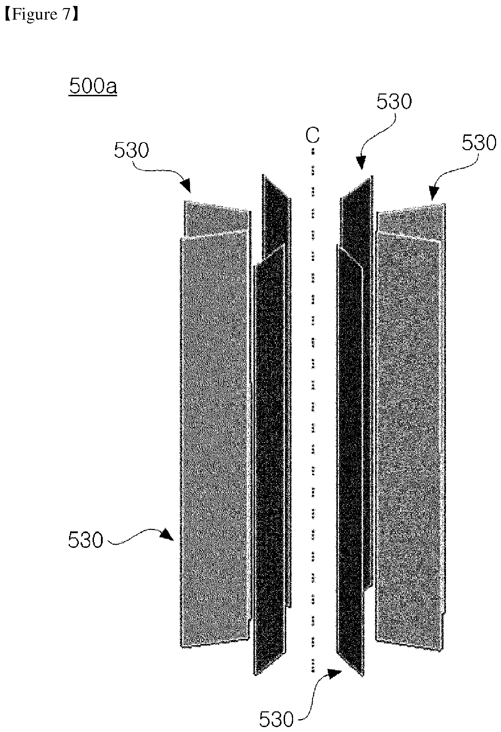

FIG. 7 is a view showing another example of the baffle of the vacuum deposition device for high-speed coating according to one embodiment of the present invention.

Referring to FIG. 7, the baffle 500a may include a plurality of plates 530.

The plurality of plates 530 may be separated from each other in a circumferential direction with respect to a virtual line C.

The steam guide unit 600 guides the steam which is prevented from rotating by the baffles 500 and 500a, and allows the steam to be sprayed onto the plating target object 2 through the injection hole 610.

In this case, the steam is sprayed through the injection hole 610, but the embodiment is not limited thereto. A nozzle (not shown) may be disposed at the injection hole 610 to allow the steam to be uniformly sprayed.

However, while the steam generated in the evaporation crucible 200 reaches the plating target object 2, a temperature may decrease. Therefore, since the steam should not be attached to inner walls of the cyclone filter 300, the connection unit 400, the baffles 500 and 500a, the steam guide unit 600, and the like, or should not be condensed, the cyclone filter 300, the connection unit 400, the baffles 500 and 500a, the steam guide unit 600, and the like should be heated to temperatures higher than a temperature at which the steam does not condense.

Therefore, as shown in FIG. 1, a heating unit 700 of the vacuum deposition device for high-speed coating 1 heats the reception space S to the temperature at which the steam does not condense or higher to prevent the steam from being condensed.

The heating unit 700 heats the reception space S of the vacuum chamber 100 to a predetermined temperature, but the embodiment is not limited thereto. The heating unit 700 may be installed to heat the cyclone filter 300, the connection unit 400, the baffles 500 and 500a, the steam guide unit 600, and the like.

While the present invention has been described with reference to the exemplary embodiments, it will be understood by those skilled in the art that various changes and modifications may be made without departing from the spirit and scope of the present invention as defined by the appended claims. It will be understood that differences related to the modification and change are included in the scope of the embodiments as defined by the following claims.

### <Description of symbols>

1: VACUUM DEPOSITION DEVICE FOR HIGH-SPEED COATING
2: PLATING TARGET OBJECT
100: VACUUM CHAMBER
200: EVAPORATION CRUCIBLE
300: CYCLONE FILTER
400: CONNECTION UNIT
500, 500A: BAFFLES
600: STEAM GUIDE UNIT
700: HEATING UNIT

## Claims

1. A vacuum deposition device for high-speed coating, the device comprising:
a vacuum chamber including a reception space provided therein;
an evaporation crucible disposed in the reception space to evaporate a coating material; and
a cyclone filter disposed in the reception space,
wherein the cyclone filter is configured to separate steam generated while the coating material is evaporated from a coarse particle.

2. The device of claim 1, further comprising a baffle configured to prevent circulation of the steam discharged through the cyclone filter.

3. The device of claim 2, wherein the baffle includes a plurality of horizontal plates separated from each other, and a plurality of vertical plates separated from each other and configured to be perpendicular to the horizontal plates,
wherein the horizontal plates and the vertical plates are integrally formed.

4. The device of claim 2, wherein the baffle is formed of a plurality of plates separated from each other in a circumferential direction with respect to a virtual line (C).

5. The device of claim 1, further comprising a connection unit disposed between the evaporation crucible and the cyclone filter.

6. The device of claim 1, further comprising a steam guide unit which guides the steam separated by the cyclone filter to be sprayed onto a plating target object.

7. The device of claim 1, wherein the cyclone filter includes a cyclone filter main body and a collecting part disposed under the cyclone filter main body,
wherein the cyclone filter main body includes an inlet formed at a side surface thereof and an outlet formed at an upper portion thereof.

8. The device of claim 7, wherein:
the steam and the coarse particle generated in the evaporation crucible evaporating the coating material are moved to the inside of the cyclone filter through the inlet;
the steam is discharged to the outlet by a cyclone method; and
the coarse particles are collected in the collecting part.

9. The device of claim 7, wherein, when an inner diameter (D1) of the cyclone filter main body is 1, a diameter (D2) of the outlet is in a range of 0.2 to 0.8, and a diameter D3 of a bottom of the collecting part is in a range of 0.1 to 0.8.

10. The device of claim 9, wherein:
a height (H1) of the cyclone filter main body is in a range of 0.3 to 5;
a height (H2) of the collecting part is in a range of 0.3 to 10;
a height (H3) of the inlet is in a range of 0.2 to 1; and
a width (W) of the inlet is in a range of 0.1 to 0.5.

11. The device of claim 1, further comprising a heating unit configured to heat the reception space to a predetermined temperature.
